# FASCICULE DE BREVET EUROPEEN

(11) **EP 1 259 847 B1**
(45) Date de publication et mention de la délivrance du brevet: **07.05.2008**
(21) Numéro de dépôt: 01909897.9
(22) Date de dépôt: 23.02.2001
(51) Int. Cl.: G02B 26/02

(54) **DISPOSITIF OPTOELECTRONIQUE SEMICONDUCTEUR A FONCTION DE TRANSFERT MODULABLE ELECTRIQUEMENT**
OPTOELEKTRONISCHE HALBLEITERVORRICHTUNG MIT ELEKTRISCH MODULIERBARER ÜBERTRAGUNGSFUNKTION
SEMICONDUCTOR OPTOELECTRONIC DEVICE WITH ELECTRICALLY ADJUSTABLE TRANSFER FUNCTION

(30) Priorité: 03.03.2000 FR 0002787
(43) Date de publication de la demande: 27.11.2002
(73) Titulaire: CENTRE NATIONAL DE LA RECHERCHE SCIENTIFIQUE (CNRS), 75794 Paris Cedex 16 (FR); ECOLE CENTRALE DE LYON, 69131 Ecully Cédex (FR)
(72) Inventeur: VIKTOROVITCH, Pierre, F-69160 Tassin-La-Demi-Lune (FR); LECLERCQ, Jean-Louis, F-69480 Morance (FR); SEASSAL, Christian, F-69004 Lyon (FR); SPISSER, Alain, F-69005 Lyon (FR); GARRIGUES, Michel, F-69890 La Tour de Salvagny (FR)
(74) Mandataire: Ramey, Daniel
(86) Numéro de dépôt international: PCT/FR2001/000547
(87) Numéro de publication internationale: WO 2001/065301

(56) Documents cités:
- EP-A- 0 465 145
- US-A- 5 559 358
- US-A- 5 739 945
- STREUBEL K ET AL: "Fabrication of InP/air-gap distributed Bragg reflectors and micro-cavities" MATERIALS SCIENCE AND ENGINEERING B,CH,ELSEVIER SEQUOIA, LAUSANNE, vol. 44, no. 1-3, 1 février 1997 (1997-02-01), pages 364-367, XP004084183 ISSN: 0921-5107

## Description

L'invention concerne les dispositifs optiques semiconducteurs à fonction de transfert spectrale modulable électriquement, et plus particulièrement les dispositifs du type « micro-opto-électro-mécanique », plus connus sous l'acronyme MOEM.

Des dispositifs de ce type sont notamment décrits dans les brevets US 5629951et US 5771253 de Chang-Hasnain *et al*. Ils comprennent plus précisément un miroir de Bragg inférieur et un miroir de Bragg supérieur constitués d'alternances de matériaux semiconducteurs d'indices de réfraction différents. Les deux miroirs de Bragg sont écartés l'un de l'autre par des espaceurs semiconducteurs, de manière à définir une cavité verticale remplie d'air, de type Fabry-Pérot. L'un des miroirs est déformable par une action électrostatique de manière à faire varier l'épaisseur de la cavité d'air et par là la réponse spectrale de la cavité Fabry-Pérot. La structure peut donc fonctionner comme un filtre accordable en longueur d'onde, ou un photodétecteur, ou encore un laser accordable en longueur d'onde.

Ces dispositifs nécessitent un déplacement solidaire de l'ensemble des couches de l'un des miroirs de Bragg, et par conséquent des champs électriques relativement importants compte tenu de la rigidité mécanique de la structure suspendue. De plus, ils ne peuvent assurer qu'une unique fonction de traitement optique des signaux (filtrage accordable), ce qui limite leur utilisation dans les composants optoélectroniques à haute intégration.

Le document US-A-5,559,358 décrit une microstructure résonante à semiconducteurs. Le document EP-A-0465145 décrit un laser à cavité verticale comprenant un miroir à réflectivité commandée.

L'article de Streubel K. et al. « Fabrication of InP/air-gap distributed Bragg reflectors and microcavities", Materials Science and Engineering B44 (1997) 364-367, Elsevier Science, décrit la fabrication de miroirs de Bragg basés sur des couches suspendues de InP.

L'invention a pour but de remédier à tout ou partie des inconvénients précités.

Elle propose à cet effet un dispositif semiconducteur selon la revendication 1.

Dans le cas d'une structure de type NIPIN ou PINIP chaque couche semiconductrice qui contribue simultanément à une sous-structure (ou jonction) PIN et à une sous-structure (ou jonction) NIP peut être déplacée selon une ou deux directions opposées de manière à faire varier soit la fonction de transfert de la sous-structure soit les fonctions de transfert de la structure. Pour ce faire, il suffit, d'une part, que la couche à déplacer soit à l'interface entre deux sous-structures de types différents (NIP et PIN) et, d'autre part que les polarisations respectives des sous-structures soient choisies de façon appropriée. Tout ajout dans la structure d'une sous-structure PIN OU NIP permet alors d'augmenter le nombre de couches qui peuvent être déplacées et par conséquent le nombre de fonctions de transfert spectrales qui peuvent être modulées.

Ainsi, le choix des épaisseurs et des compositions respectives des couches semiconductrices et des espaceurs permet à la structure d'assurer une (ou plusieurs) fonction(s) de transfert modulable(s) adaptée(s) aux fonctions choisies dans un groupe comprenant au moins le filtrage en longueur d'onde, la commutation et l'accordabilité (ou d'autres fonctions), en fonction de la succession d'alternances choisies.

Dans le cas d'une structure de type NIPIN, respectivement PINIP, les deux couches d'extrémités de type N, respectivement P, qui encadrent la couche centrale de type P, respectivement N, sont avantageusement placées sous des potentiels électriques différents de sorte que la structure forme deux sous-structures PIN et NIP placées en série et polarisées respectivement en inverse et en direct. Dans ce cas, la modulation de la fonction de transfert est obtenue par le déplacement (électro-mécanique) de la couche centrale de type N, respectivement P, « vers le haut ou vers le bas », relativement aux deux couches d'extrémités de type P, respectivement N, en faisant varier les polarisations respectives appliquées aux sous-structures PIN et NIP.

Des modes de réalisation différents et/ou plus complexes peuvent être envisagés. Le dispositif pourra notamment comprendre une (ou plusieurs) couche(s) semiconductrice(s) supplémentaire(s) (ou additionnelles(s)) intentionnellement dopée(s) de type N, respectivement de type P, placée(s) en amont ou en aval, de l'une des couches de type N, respectivement de type P, de la structure PINIP ou NIPIN, et espacée(s) de celle-ci par des espaceurs non intentionnellement dopés « I » ou dopés N ou P pour former une nouvelle structure de type NIPINIP ou PINIPIN, ou bien NIPPPIN ou PPPINIP ou PINNNIP, ou encore NNNIPPPIN ou PPPINNNIP, par exemple.

On forme ainsi un dispositif multifonctions présentant plusieurs fonctions de transfert modulables adaptées aux fonctions de filtrage en longueur d'onde, de commutation ou d'accordabilité, ou analogue.

L'une au moins des couches semiconductrices du dispositif pourra être active de sorte qu'il soit adapté à la détection ou la génération de lumière.

Par ailleurs, la structure du dispositif pourra être formée sur un substrat avec interposition éventuelle d'espaceurs de dimensions et dopages choisis.

Préférentiellement, les couches semiconductrices et les espaceurs sont réalisés dans des matériaux de type III-V, en particulier en arséniure de gallium (GaAs) ou en phosphure d'indium (InP). Par ailleurs, ces couches semiconductrices et espaceurs sont préférentiellement réalisés à l'aide de techniques d'épitaxie couplées à des techniques d'attaque chimique sélective.

D'autres caractéristiques et avantages de l'invention apparaîtront à l'examen de la description détaillée ci-après, et des dessins annexés, sur lesquels :
- la figure 1 est une vue schématique en perspective d'un dispositif selon l'invention de type PINIP, adapté à la commutation,
- les figures 2A et 2B sont des vues en coupe transversale d'une partie du dispositif illustré sur la figure 1, respectivement sans polarisation et avec polarisation,
- la figure 2C montre les fonctions de transfert des dispositifs des figures 2A (traits pleins) et 2B (tirets),
- les figures 3A à 3C sont des vues en coupe transversale d'une partie d'une variante du dispositif, respectivement sans polarisation, avec une première polarisation et avec une seconde polarisation,
- la figure 4 montre les fonctions de transfert des dispositifs des figures 3A à 3C, et
- les figures 5A et 5B sont des vues de côté d'une partie d'une autre variante de dispositif, dans laquelle l'une des couches est active, respectivement sans polarisation et avec polarisation.

Les dessins annexés sont, pour l'essentiel, de caractère certain. En conséquence, ils pourront non seulement servir à compléter l' invention, mais aussi contribuer à sa définition, le cas échéant.

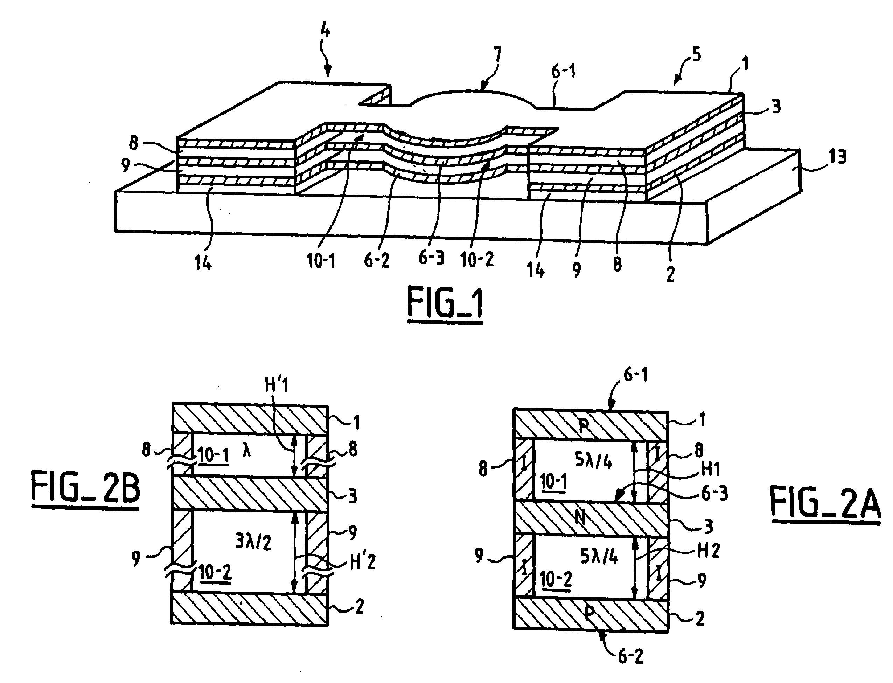

On se réfère tout d'abord à la figure 1 pour décrire un premier mode de réalisation d'un dispositif selon l'invention, destiné au traitement optique d'une lumière externe.

Dans l'exemple illustré sur la figure 1, le dispositif comporte trois couches semiconductrices, dont deux couches d'extrémité 1, 2 encadrant une couche centrale 3. Ces couches présentent de préférence des formes sensiblement identiques. Dans l'exemple illustré, les couches comportent deux extrémités 4, 5 de forme sensiblement rectangulaire, reliées l'une à l'autre par une lame 6-i (ici, i = 1 à 3) présentant, dans une partie centrale, un élargissement 7.

Les couches voisines sont espacées par des couches de séparation (ou espaceurs) 8, 9. Plus précisément, ces espaceurs 8,9 sont formés au niveau des extrémités 4, 5 des couches semiconductrices 1-3, de sorte que leurs lames 6-i soient suspendues et séparées les unes des autres par des couches d'air.

En quelque sorte, chaque lame d'extrémité 6-1, 6-2 d'une couche d'extrémité 1, 2 définit avec la lame centrale 6-3 une cavité verticale 10-1, 10-2 dont la hauteur H1, H2 est fixée par l'épaisseur des espaceurs 8,9.

Comme illustré sur les figures, une telle structure est de préférence formée sur un substrat semiconducteur 13, avec interposition d'espaceurs 14, de sorte que la lame d'extrémité 6-2 soit également suspendue à distance choisie (égale à la hauteur des espaceurs 14) au dessus du substrat 13. Un tel dispositif peut être associé à des moyens de couplage (par exemple des fibres optiques) destinés à introduire la lumière à traiter et collecter la lumière traitée. Selon l'invention, les couches 1-3 et les espaceurs 8, 9, 14 sont réalisés dans des matériaux semiconducteurs, et de préférence dans des matériaux semiconducteurs de type III-V. II s'agira, par exemple, d'arséniure de gallium (GaAs) ou de phosphure d'indium (InP), ou bien d'hétérostructures de type InGaAs/InP ou InAlAs/InGaAlAs déposées sur un substrat d'InP, ou de type AlAs/GaAs déposées sur un substrat GaAs, ou encore de type InGaP/GaAs déposées sur un substrat GaAs.

Bien entendu, ces matériaux ne constituent que des exemples préférentiels.

Dans l'exemple illustré sur la figure 1, les couches semiconductrices d'extrémités 1 et 2, qui encadrent la couche semiconductrice centrale 3, sont intentionnellement dopées de type N ou de type P, et la couche semiconductrice centrale 3 est intentionnellement dopée de type P ou de type N de sorte que les types de dopage de deux couches voisines soient différents. Par ailleurs, les espaceurs 8, 9 sont réalisés dans des matériaux semiconducteurs non intentionnellement dopés (de type I) de sorte que le dispositif constitue une structure de type PINIP, lorsque les couches semiconductrices d'extrémités 1 et 2 sont de type P, ou bien de type NIPIN, lorsque les deux couches d'extrémités sont de type N. Le substrat 13 et les espaceurs 14 peuvent être préférentiellement de type I.

La structure ainsi formée est constituée de deux sous-structures PIN et NIP qui présentent une couche commune, à savoir la couche centrale 3. En d'autres termes, dans une structure de type PINIP la sous-structure PIN partage sa couche dopée N avec la sous-structure NIP, tandis que dans une structure de type NIPIN, la sous-structure NIP partage sa couche dopée P avec la sous-structure PIN.

II est clair que chaque sous-structure PIN ou NIP constitue ainsi une jonction PIN bien connue de l'homme du métier.

Afin de faciliter la compréhension du texte, on considère dans ce qui suit que dans une structure PINIP la jonction PIN est placée au-dessus de la jonction NIP. En d'autres termes, la lame d'extrémité 6-1, de type P, est la lame supérieure, tandis que la lame d'extrémité 6-2, également de type P, est la lame inférieure.

L'épaisseur et la composition de chacune des couches semiconductrices et de chaque espaceur 1, 3, 14, et par conséquent les hauteurs H1 et H2 des cavités 10-1 et 10-2, sont choisies en fonction de la longueur d'onde de travail du dispositif et de la fonction de transfert à réaliser. A titre d'exemple, et comme illustré sur la figure 2A (où les échelles ne sont pas respectées), les couches semiconductrices d'extrémités 1 et 2 et la couche semiconductrice centrale 3 peuvent présenter une épaisseur optique sensiblement égale à kλ/4 où k est un entier impair, tandis que les hauteurs respectives H1 et H2 des deux cavités 10-1 et 10-2 sont sensiblement égales à 5λ/4 (figure 2A). Les espaceurs 14 sont choisis d'une épaisseur égale à λ/2. Dans ces conditions la structure est configurée en réflecteur de Bragg (miroir) à la longueur d'onde λ.

Par exemple, pour que le dispositif fonctionne en tant que commutateur, il suffit de moduler sa fonction de transfert pour qu'elle passe de l'état de repos assurant une fonction de miroir (figure 2A) à un état assurant une fonction de transmetteur (figure 2B), et réciproquement

Selon l'invention, la modulation de la fonction de transfert est obtenue par un déplacement électromécanique de l'une au moins des lames 6-i, et de préférence de la lame centrale 6-3. Pour privilégier le déplacement de cette lame, elle présente par exemple une épaisseur λ/4 alors que les lames 6-1 et 6-2 présentent une épaisseur 3λ/4.

Ce déplacement est obtenu en choisissant les polarisations respectives de chacune des cavités 10-1, 10-2, ou en d'autres termes en choisissant les potentiels respectifs appliqués aux couches semiconductrices de la structure.

En effet, comme cela est illustré sur la figure 2A, en l'absence de polarisation, la lame centrale 6-3 est dans une position de repos (ou d'équilibre). En revanche, comme cela est illustré sur la figure 2B, lorsque la jonction PIN (constituée par la couche supérieure 1 et la couche centrale 3) est polarisée en inverse, et que dans le même temps la jonction NIP (constituée de la couche centrale 3 et de la couche inférieure 2) est polarisée en direct, tout le champ électrique est subi par la cavité supérieure 10-1 formée par la jonction PIN. La lame centrale 6-3 est par conséquent attirée par la lame supérieure 6-1 sur une distance choisie, dépendante des potentiels appliqués aux couches et des caractéristiques des cavités. Les deux sous-structures PIN et NIP étant placées en série, les conditions de polarisation décrites sont obtenues simplement en plaçant la lame 6-1 à un potentiel négatif par rapport à la lame 6-3. Si on inverse cette polarisation en plaçant la lame 6-3 à un potentiel négatif par rapport à la lame 6-1, le champ électrique est alors appliqué sur la cavité inférieure 10-2 et la lame 6-2 est attirée par la lame 6-3.

A titre d'exemple, lorsque le déplacement vertical de la lame centrale 6-3 est sensiblement égal à λ/4 (figure 2B) et que la hauteur H1 de la cavité supérieure 10-1 est sensiblement égale à 5λ/4, alors la nouvelle hauteur de la cavité H'1 devient égale à 5λ/4 - λ/4, soit λ, pour le premier cas de polarisation envisagé. De même, la hauteur H2 de la cavité inférieure 10-2 devient H'2, égale à 5λ/4 + λ/4, soit 3λ/2. Dans ces conditions de polarisation la structure passe de l'état de miroir à l'état de transmetteur sur une gamme de longueurs d'onde large, ce qui lui permet de fonctionner en tant que commutateur.

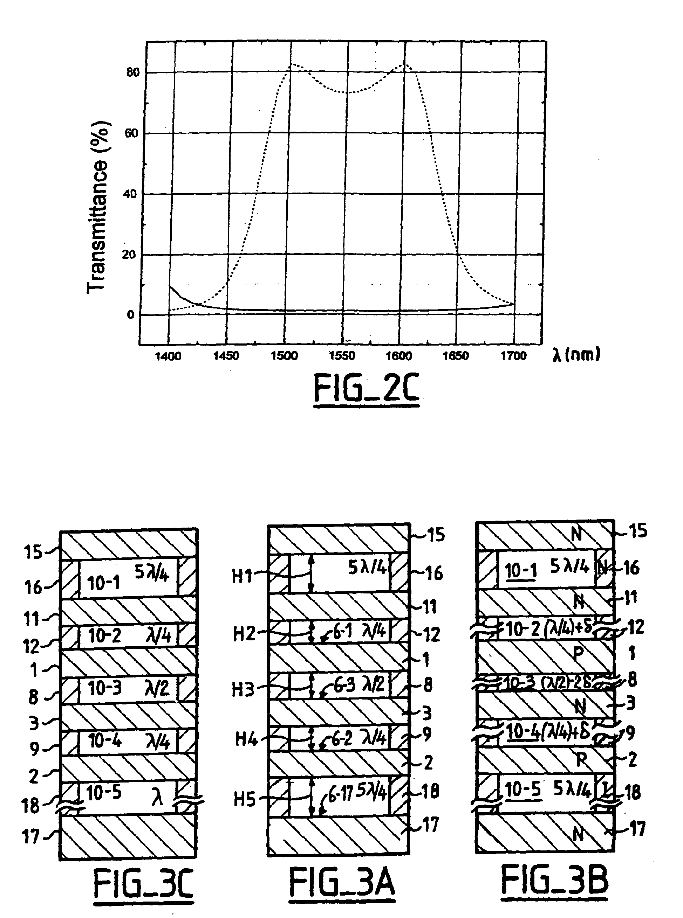

La fonction de transfert de la structure au repos (figure 2A, traits pleins) et sous polarisation (figure 2B, tirets) est donnée sur la figure 2C pour une longueur d'onde de configuration λ = 1,55 µm ; le substrat ainsi que les lames suspendues sont en InP, et les espaceurs en In_{0,53}Ga_{0.47}As.

De nombreuses autres fonctions peuvent être envisagées pour d'autres modes de réalisation de la structure. On citera, à titre d'exemple, la réalisation simultanée avec un seul dispositif des fonctions de filtrage en longueur d'onde, qu'il soit en large bande ou en bande(s) étroite(s), assorti des fonctions de commutation et d'accordabilité en longueur d'onde.

L'accordabilité et la commutation sont contrôlées par les tensions de polarisation appliquées aux couches semiconductrices.

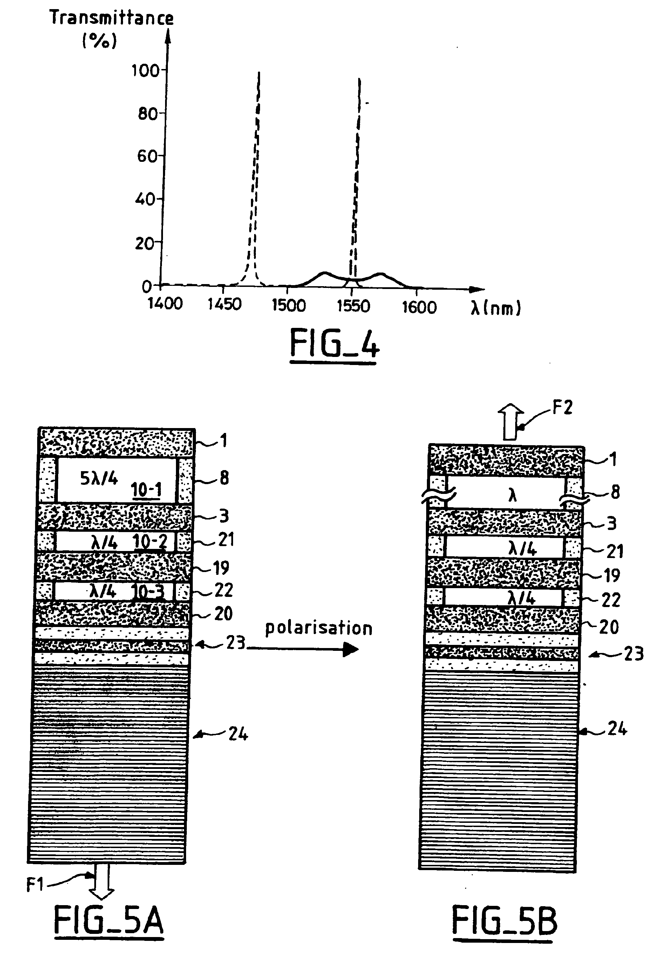

La possibilité d'assurer avec une même structure plusieurs fonctions constitue un avantage important de l'invention. Pour ce faire, on peut adjoindre à la structure de type PINIP illustrée sur les figures 1 et 2 (ou à une structure à trois couche d'un autre type, comme par exemple NIPIN), une ou plusieurs couches semiconductrices supplémentaires (ou additionnelles) en amont et/ou en aval des couches d'extrémités 1 et 2, comme illustré à titre d'exemple sur les figures 3A-3C, 5A et 5B.

Plus précisément, dans l'exemple illustré sur la figure 3A la structure, initialement de type PINIP, comporte, en amont (au-dessus) de la couche supérieure 1, de type P, une première couche semiconductrice 11 présentant un dopage intentionnel de type N et espacée de cette couche supérieure 1 par des espaceurs semiconducteurs 12 non intentionnellement dopés (de type I), puis, au dessus de cette première couche 11, une seconde couche semiconductrice 15 présentant un dopage intentionnel de type N et espacée de cette couche 11 par des espaceurs semiconducteurs 16 intentionnellement dopés N. De plus, la structure comporte en aval (en-dessous) de la couche inférieure 2, de type P, une troisième couche semiconductrice 17 présentant un dopage intentionnel de type N et espacée de cette couche inférieure 2 par des espaceurs semiconducteurs 18 non intentionnellement dopés (de type I). Les première 11, seconde 15 et troisième 17 couches semiconductrices présentent des dimensions sensiblement identiques à celles des autres couches 1-3.

Cette structure, de type NNNIPINIPIN, délimite cinq cavités d'air 10-1 à 10-5 entre la couche 15 dopée N, placée à l'extrémité supérieure, et la couche 17 également dopée N, placée à l'extrémité inférieure.

Les couples de couches 15 et 11 d'une part, et 2 et 17 d'autre part, constituent des miroirs de Bragg.

Les épaisseurs optiques des couches 1-3, 11, 15 et 17 sont sensiblement égales à kλ/4 ou k est un nombre entier impair, tandis que les épaisseurs H1 à H5 des cavités 10-1 à 10-5 sont respectivement sensiblement égales à 5λ/4, λ/4*,* λ/2, λ/4 et 5λ/4. Comme cela est illustré sur la courbe de transmittance de la figure 4 (en tirets), une telle structure, lorsqu'elle n'est pas polarisée, est un filtre passe-bande dont la fonction de transfert optique assure la transmission d'une lumière centrée sur une longueur d'onde d'environ 1550 nm.

En jouant sur les potentiels appliqués aux différentes couches, ou en d'autres termes en polarisant certaines jonctions PIN (ou NIP), on peut déplacer une ou plusieurs couches, et par conséquent moduler la fonction de transfert optique de la structure.

Plus précisément, comme illustré sur la figure 3B, en modulant l'épaisseur de la cavité d'air centrale 10-3, d'épaisseur optique H3 = λ/2, on peut changer la longueur d'onde nominale transmise par le filtre passe-bande pour transmettre, par exemple, une lumière centrée sur une longueur d'onde d'environ 1470 nm (voir la courbe de gauche de la figure 4).

Cette modulation s'obtient en déplaçant la partie centrale (lame 6-1) de la couche 1 vers le bas sur une hauteur δ et la partie centrale (lame 6-3) de la couche 3 vers le haut, également sur une hauteur δ, de sorte que les cavités 10-2 à 10-4 présentent des hauteurs respectives H2, H3 et H4 sensiblement égales à (λ/4) + δ, (λ/2) - 2δ et (λ/4) + δ. La structure agit donc en tant que filtre accordable.

De plus, comme illustré sur la figure 3C, en modulant l'épaisseur de la cavité d'air inférieure 10-5 d'épaisseur optique H5 = 5λ/4, c'est-à-dire en dégradant la réflectivité de l'un des réflecteurs de Bragg, on transforme la structure qui agissait au repos (hors polarisation) comme un filtre, dont la fonction de transfert optique assurait la transmission d'une lumière centrée sur une longueur d'onde d'environ 1550 nm, en un réflecteur dont la transmittance (fonction de transfert) est donnée en trait continu sur la figure 4.

Cette modulation s'obtient en déplaçant la partie centrale (lame 6-17) de la couche inférieure 17 vers le haut, sur une hauteur λ/4, de sorte que la cavité 10-5 présente une hauteur H5 sensiblement égale à λ (au lieu de 5λ/4). La structure agit alors en tant que commutateur.

La structure illustrée sur les figures 3A à 3C assure donc au moins les fonctions de filtrage accordable et de commutation, sur une gamme de longueurs d'onde large.

On notera ici que grâce à l'utilisation d'un empilement de type NNNIPINIPIN, on peut appliquer les polarisations nécessaires à l'application d'un champ électrique aux bornes de l'une quelconque des quatre cavités 10-2, 10-3, 10-4 et 10-5 en utilisant seulement trois contacts électriques connectés respectivement aux couches extrêmes 15 et 17 et à la couche intermédiaire 3.

Plus généralement, d'autres structures peuvent être envisagées sur la base d'une structure de type PINIP ou NIPIN, en remplaçant l'une au moins de leurs couches semiconductrices (initiales, N ou P) par au moins deux couches semiconductrices de même type de dopage (N ou P) séparées par des espaceurs de même type de dopage (N ou P) que la couche initiale et présentant une forme sensiblement identique à la forme des couches de la structure. Ainsi, on peut former des structures de type NIPPPIN, ou PPPINIP, ou PINNNIP, ou encore NNNIPPPIN ou PPPINNNIP, par exemple.

Comme cela est mieux illustré sur la figure 5A, le dispositif peut comporter également une ou plusieurs couches actives de manière à permettre la génération ou la détection de lumière, combinée à une ou plusieurs fonctions passives du type de celles évoquées précédemment (filtrage, accordabilité, commutation, etc.).

Dans cet exemple, la structure comporte dans sa partie supérieure une sous-structure semiconductrice de type PIN constituée d'une couche supérieure 1 dopée P, espacée d'une couche inférieure 3 dopée N par des espaceurs 8 non intentionnellement dopés (I). Elle comporte également dans sa partie inférieure (en dessous de la couche 3) deux couches semiconductrice 19 et 20 présentant un dopage intentionnel de type N et espacées entre elles et de la couche 3 par des espaceurs semiconducteurs 21 et 22 dopés N. De plus, la structure comporte en-dessous de la couche 20, et contre celle-ci, des couches actives formant un laser 23 de type à cavité verticale, émettant par la surface, et en-dessous de ce laser 23, et contre celui-ci, une alternance de couches semiconductrices de deux types formant un miroir de Bragg inférieur 24.

Dans cet exemple, les alternances cavité d'air-semiconducteur placées au-dessus du laser 23 forment un miroir de Bragg supérieur. Ici, les cavités 10-1 à 10-3 présentent des hauteurs respectives H1, H2 et H3 sensiblement égales à 5λ/4, λ/4 et λ/4.

Au repos (hors polarisation) la partie supérieure de la structure constituée des couches 1, 3, 19 et 20 agit en tant que miroir, et la lumière générée par le laser 23 est contrainte à sortir de la structure par le miroir de Bragg inférieur 24 (suivant la flèche F1).

En revanche, lorsque l'on polarise de façon appropriée la partie supérieure de la structure (formant le miroir de Bragg supérieur), on peut contraindre l'une (ou plusieurs) des lames suspendues à se déplacer de manière à modifier la hauteur H1 de la cavité 10-1. Dans l'exemple illustré sur la figure 5B on déplace la lame 6-1 de la couche 1 vers le bas, d'une hauteur égale à environ λ/4, de sorte que la hauteur H1 de la cavité 10-1 passe de la valeur 5λ/4 à la valeur λ. Cette modulation de la réflectivité du miroir de Bragg supérieur modifie sa fonction de transfert et lui confère une fonction de transmission. L'émission du laser est alors préférentiellement dirigée vers le haut, contraignant ainsi la lumière émise à sortir par le haut de la structure, suivant la flèche F2.

Dans cet exemple de réalisation, la structure agit donc comme un générateur de lumière et comme un dispositif d'aiguillage.

Les dispositifs selon l'invention sont préférentiellement réalisés par une technique d'épitaxie combinée à une ou plusieurs techniques d'attaque chimique sélective. Différentes techniques d'épitaxie peuvent être envisagées, dès lors qu'elles permettent un contrôle des épaisseurs des couches, à l'échelle de la couche atomique. On citera par exemple l'épitaxie par jet moléculaire (plus connue sous l'acronyme anglais MBE), ou bien la déposition chimique en phase vapeur d'organométalliques à basse pression (plus connue sous l'acronyme anglais « LP-MOCVD »), ou encore l'épitaxie par jet chimique sous pression (plus connue sous l'acronyme anglais « CBE »).

Ces techniques permettent un contrôle des épaisseurs à l'échelle de la couche atomique et assurent d'excellentes qualités cristallines et des interfaces très abruptes. De plus, elles offrent un contrôle de la composition et du dopage d'une très grande précision. Enfin, elles permettent un excellent contrôle des contraintes mécaniques résiduelles.

II existe, par ailleurs, de nombreuses techniques de gravure chimique, notamment par voie humide, permettant un micro-usinage sélectif des parties suspendues (lames). On citera à titre d'exemple les techniques de gravure par voie humide de type FeCl₃:H₂O ou HF:H₂O₂:H₂O pour le système InGaAs/InP, ou bien de type HCl :H₂O ou HCl :H₃PO₄ pour les systèmes InAlAs/InGaAlAs et GalnP/GaAs, ou encore de type HF pour le système AlAs/GaAs.

Bien entendu, il ne s'agit que d'exemples de techniques de croissance et de gravure, parmi d'autres.

Par ailleurs, les tensions sont appliquées aux couches semiconductrices par des contacts ohmiques, de préférence réalisés en alliages de type AuGe, ou bien Pd-AuGe, ou encore Ti-Pt-Au. Ces contacts sont formés sur les couches placées aux deux extrémités de la structure, ou bien sur chaque couche semiconductrice de la structure, ou bien encore sur les couches d'extrémité et sur certaines couches intermédiaires. Comme indiqué précédemment, il est particulièrement avantageux d'utiliser des matériaux de type III-V pour élaborer les couches semiconductrices et les espaceurs. En effet, et comme exposé ci-avant, les hétérostructures en matériau III-V présentent des contraintes mécaniques résiduelles très faibles, mais surtout contrôlées, qui assurent aux lames suspendues une flexibilité relativement importante, indispensable à leurs déplacements électromécaniques.

Mais, d'autres matériaux peuvent être envisagés. On citera, à titre d'exemples, le silicium cristallin et le silicium polycristallin. Les structures en silicium cristallin peuvent être obtenues à l'aide de technologies de type SOI par attaque des couches de silice (SiO₂), technique plus connue sous son appellation anglaise "smart cut".

Les structures polycristallines peuvent être envisagées, mais la flexibilité des lames n'est pas très bonne du fait du mauvais contrôle des contraintes mécaniques et des possibilités d'absorption de la lumière qui limitent les applications de filtrage.

Par ailleurs, le silicium ne peut pas être utilisé, actuellement, dans les dispositifs intégrant des couches actives. En conséquence, ils ne peuvent être utilisés que sous la forme de composants passifs.

Les dispositifs selon l'invention offrent de nombreux avantages, dans la mesure où ils présentent des dimensions réduites permettant leur utilisation dans des composants électroniques à haute intégration. A titre d'exemple, ils peuvent être utilisés en tant que laser accordable sur GaAs ou InP, ou en tant que photodétecteur accordable, résonnant ou non, ou encore en tant que modulateur, en utilisant la fonction de commutation à une longueur d'onde donnée (la modulation peut être de type détection synchrone de sorte que la détection s'effectue sur un signal utile modulé, dépourvu de parasites modulés comme c'est le cas lorsque l'on utilise un hacheur).

Mais bien d'autres applications peuvent être envisagées, comme dans le domaine des télécommunications optiques, du contrôle industriel (par exemple dans l'agro-alimentaire), de la microspectrométrie, notamment dans le domaine de l'environnement (détection de transmission ou d'absorption de gaz), ou encore dans le domaine de l'analyse médicale.

D'une manière générale, le dispositif selon l'invention est particulièrement adapté aux traitements optiques des signaux.

## Revendications

1. Dispositif semiconducteur, comprenant une alternance d'au moins trois couches semiconductrices (1-3) de forme choisie et deux couches d'air,
* lesdites couches semiconductrices comprenant deux couches extrêmes (1,2) présentant des dopages d'un même type N, respectivement P, tandis qu'au moins une troisième couche intermédiaire (3) présente un dopage de type P, respectivement N, qui est différent du dopage desdites couches extrêmes (1-2), chacune des au moins trois couches semi-conductrices (1-3) comportant deux extrémités (4, 5), les au moins trois couches semiconductrices (1-3) étant séparées l'une par rapport à l'autre dans leurs parties d'extrémité (4, 5) par des espaceurs (8, 9) semiconducteurs non intentionnellement dopés, du type I, et ayant des parties (6) centrales flexibles, suspendues et déplaçables par action électrostatique et définissant entre elles une structure à cavités d'air (10-1, 10-2) comportant au moins deux sous-structures de type PIN, et étant propres à être placées à des potentiels électriques respectifs choisis, et
* les épaisseurs, compositions et dopages respectifs desdites couches semiconductrices (1-3) et espaceurs (8,9) étant choisis de sorte que la structure présente au moins une fonction de transfert optique adaptée à une fonction de traitement d'une lumière et modulable en fonction desdits potentiels choisis appliqués aux couches semiconductrices de manière à les déformer par action électrostatique, ladite fonction de traitement étant choisie dans un groupe comprenant le filtrage en longueur d'onde, la commutation et l'accordabilité.

2. Dispositif selon la revendication 1, **caractérisé en ce qu'**il comprend au moins un empilement constitué de deux couches (1, 2) dopées N encadrant une couche (3) dopée P, lesdites couches (1, 2, 3) étant séparées par des espaceurs (8,9) non intentionnellement dopés de type « I » de manière à former une structure de type NIPIN, et lesdites couches dopées N étant placées sous des potentiels différents choisis de sorte que la structure définisse deux sous-structures NIP et PIN placées en série, l'une desdites sous-structures étant polarisée en inverse pendant que l'autre sous-structure est polarisée en direct, ladite modulation de la fonction de transfert étant obtenue par un déplacement de la couche encadrée dopée P, relativement aux deux couches dopées N, par une variation des polarisations respectives appliquées aux sous-structures NIP et PIN.

3. Dispositif selon la revendication 1, **caractérisé en ce qu'**il comprend au moins un empilement constitué de deux couches (1, 2) dopées P encadrant une couche (3) dopée N, lesdites couches (1, 2, 3) étant séparées par des espaceurs (8, 9) non intentionnellement dopés de type « I » de manière à former une structure de type PINIP, et lesdites couches dopées P étant placées sous des potentiels différents choisis de sorte que la structure définisse deux sous-structures PIN et NIP placées en série, l'une desdites sous-structures étant polarisée en inverse pendant que l'autre sous-structure est polarisée en direct, ladite modulation de la fonction de transfert étant obtenue par un déplacement de la couche encadrée (3) dopée N, relativement aux deux couches (1, 2) dopées P, par une variation des polarisations respectives appliquées aux sous-structures PIN et NIP.

4. Dispositif selon la revendication 2 ou 3, **caractérisé en ce qu'**il comporte au une couche additionnelle semiconductrice présentant un dopage de même type (N ou P) que l'une au moins des couches semiconductrices (1,2,3) formant u ne structure d e type PINIP ou NIPIN, espacée de cette couche (1, 2, 3) par des espaceurs présentant un même type de dopage (N ou P) que le sien, et présentant une forme sensiblement identique à la forme des couches (1-3) de la structure.

5. Dispositif suivant l'une des revendications précédentes, **caractérisé en ce que** les épaisseurs et compositions respectives des couches semiconductrices et des espaceurs sont choisies de sorte que la structure présente une fonction de transfert optique modulable réalisant un filtrage sélectif accordable en longueur d'onde.

6. Dispositif suivant l'une des revendications précédentes **caractérisé en ce que** les épaisseurs et compositions respectives des couches semiconductrices et des espaceurs sont choisies de sorte que la structure présente au moins une fonction de transfert optique modulable supplémentaire réalisant une fonction choisie dans un groupe comprenant le filtrage en longueur d'onde, la commutation et l'accordabilité.

7. Dispositif selon l'une des revendications précédentes, **caractérisé en ce qu'**il comporte au moins une couche active semiconductrice (23) adaptée à la détection ou la génération de lumière.

8. Dispositif selon l'une des revendications précédentes, **caractérisé en ce qu'**au moins deux (1,2,11) desdites couches (1-3,11) comprennent un contact ohmique adapté à l'application de potentiel électrique.

9. Dispositif selon l'une des revendications précédentes, **caractérisé en ce qu'**il est formé sur un substrat (13).

10. Dispositif selon la revendication 9, **caractérisé en ce qu'**il est formé sur ledit substrat (13) avec interposition d'espaceurs (14) de dimensions et de dopage choisis.

11. Dispositif selon l'une des revendications précédentes, **caractérisé en ce que** les couches semiconductrices (1-3,11,15,17,19,20) et les espaceurs (8,9,12,14,16,18,21,22) sont réalisés dans des matériaux de type III-V, en particulier en arséniure de gallium (GaAs) ou en phosphure d'indium (InP).

## Claims

1. A semiconductor device comprising in alternation at least three semiconductor layers (1-3) of selected shape and two layers of air,
· said semiconductor layers comprising two extreme layers (1, 2) presenting dopings of the same N or P type respectively, while at least one intermediate third layer (3) presents doping of the P or N type respectively that is different from the doping of said extreme layers (1, 2), each of said at least three semiconductor layers (1-3) having two ends (4, 5), the at least three semiconductor layers (1-3) being separated from one another in their end portions (4, 5) by I-type semiconductor spacers (8, 9) that are not intentionally doped and having flexible central portions (6) that are suspended and movable by electrostatic action and defining between them a structure with air cavities (10-1, 10-2) including at least two PIN type substructures, and being suitable for being placed at respective selected electric potentials; and
the respective thicknesses, compositions, and dopings of said semiconductor layers (1-3) and spacers (8, 9) being selected in such a manner that the structure presents at least optical transfer function adapted to a light processing function and capable of being modulated as a function of said selected potentials applied to the semiconductor layers so as to deform them by electrostatic action, said processing function being selected from a group comprising wavelength filtering, switching, and tunability.

2. A device according to claim 1, **characterized in that** it comprises at least one stack made up of two N-doped layers (1, 2) on either side of a P-doped layer (3), said layers (1, 2, 3) being separated by I-type spacers (8, 9) that are not intentionally doped so as to form a structure of NIPIN type, said N-doped layers being placed at different selected potentials such that the structure defines two substructures placed in series, an NIP substructure and a PIN substructure, one of said substructures being reverse biased while the other substructure is forward biased, said modulation of the transfer function being obtained by moving the in-between P-doped layer relative to the two N-doped layers by varying the respective biases applied to the NIP and PIN substructures.

3. A device according to claim 1, **characterized in that** it comprises at least one stack made up of two P-doped layers (1, 2) on either side of a N-doped layer (3), said layers (1, 2, 3) being separated by I-type spacers (8, 9) that are not intentionally doped so as to form a structure of PINIP type, said P-doped layers being placed at different selected potentials such that the structure defines two substructures placed in series, a PIN substructure and an NIP substructure, one of said substructures being reverse biased while the other substructure is forward biased, said modulation of the transfer function being obtained by moving the in-between N-doped layer (3) relative to the two P-doped layers (1, 2) by varying the respective biases applied to the PIN and NIP substructures.

4. A device according to claim 2 or claim 2, **characterized in that** it includes an additional semiconductor layer presenting doping of the same type (N or P) as at least one of the semiconductor layers (1, 2, 3) forming a PINIP or NIPIN type structure, spaced apart from said layer (1, 2, 3) by spacers presenting doping (N or P) of the same type as its own doping, and presenting a shape that is substantially identical to the shape of the layers (1-3) of the structure.

5. A device according to any preceding claim, **characterized in that** the respective thicknesses and compositions of the semiconductor layers and the spacers are selected in such a manner that the structure presents an optical transfer function that can be modulated, thereby performing wavelength tunable selective filtering.

6. A device according to any preceding claim, **characterized in that** the respective thicknesses and compositions of the semiconductor layers and the spacers are selected in such a manner that the structure presents at least one additional optical transfer function that can be modulated, thereby performing a function selected from a group comprising wavelength filtering, switching, and tunability.

7. A device according to any preceding claim, **characterized in that** it includes at least one active semiconductor layer (23) adapted to detecting or generating light.

8. A device according to any preceding claim, **characterized in that** at least two (1, 2, 11) of said layers (1-3, 11) includes an ohmic contact adapted to applying electric potential.

9. A device according to any preceding claim, **characterized in that** it is formed on a substrate (13).

10. A device according to claim 9, **characterized in that** it is formed on said substrate (13) with interposition of spacers (14) of selected dimensions and doping.

11. A device according to any preceding claim, **characterized in that** the semiconductor layers (1-3, 11, 15, 17, 19, 20) and the spacers (8, 9, 12, 14, 16, 18, 21, 22) are made out of III-V materials, in particular out of gallium arsenide (GaAs) or out of indium phosphide (InP).

## Patentansprüche

1. Halbleitervorrichtung mit wenigstens drei Halbleiterschichten (1-3) ausgewählter Form und zwei Luftschichten in alternierender Anordnung,
* wobei die Halbleiterschichten zwei äußere Schichten (1, 2) aufweisen, die mit demselben n-Typ bzw. p-Typ dotiert sind, während wenigstens eine dritte dazwischenliegende Schicht (3) eine p-Typ-Dotierung bzw. n-Typ-Dotierung aufweist, die sich von der Dotierung der äußeren Schichten (1-2) unterscheidet, wobei jede der wenigstens drei Halbleiterschichten (1-3) zwei Enden (4, 5) aufweist, wobei die wenigstens drei Halbleiterschichten (1-3) in ihren Endbereichen (4, 5) durch unbeabsichtigt dotierte i-Halbleiter-Abstandsschichten (8, 9) voneinander getrennt sind und flexible Mittelteile (6) haben, die schwebend angeordnet und durch elektrostatische Wirkung verlagerbar sind und untereinander eine wenigstens zwei pin-Unterstrukturen umfassende Struktur (10-1, 10-2) mit Lufthohlräumen bilden und an jeweils ausgewählte elektrische Spannungen angelegt zu werden vermögen, und
* wobei die jeweiligen Dicken, Zusammensetzungen und Dotierungen der Halbleiterschichten (1-3) und Abstandsschichten (8, 9) solchermaßen gewählt sind, dass die Struktur wenigstens eine optische Übertragungsfunktion aufweist, die für eine Lichtverarbeitungsfunktion geeignet und in Abhängigkeit von den gewählten Spannungen modulierbar ist, die an die Halbleiterschichten angelegt sind, um diese durch elektrostatische Wirkung zu verformen, wobei die Verarbeitungsfunktion aus einer Gruppe gewählt ist, welche die Wellenlängenfilterung, die Kommutierung und die Abstimmbarkeit umfasst.

2. Vorrichtung nach Anspruch 1,
**dadurch gekennzeichnet, dass** sie wenigstens einen Stapel aus zwei n-dotierten Schichten (1, 2) aufweist, die eine p-dotierte Schicht (3) einfassen, wobei die Schichten (1, 2, 3) durch unbeabsichtigt dotierte i-Abstandsschichten (8, 9) getrennt sind, um eine nipin-Struktur zu bilden, und wobei die n-dotierten Strukturen an unterschiedliche Spannungen angelegt sind, die solchermaßen gewählt sind, dass die Struktur zwei hintereinander angeordnete nip- und pin-Unterstrukturen bildet, wobei eine der Unterstrukturen in Sperrrichtung polarisiert ist, während die andere Unterstruktur in Flussrichtung polarisiert ist, wobei die Modulation der Übertragungsfunktion durch ein Verschieben der eingefassten p-dotierten Schicht gegenüber den beiden n-dotierten Schichten durch eine Änderung der jeweiligen an die nip- und pin-Unterstrukturen angelegten Polarisierungen erreicht wird.

3. Vorrichtung nach Anspruch 1,
**dadurch gekennzeichnet, dass** sie wenigstens einen Stapel mit zwei p-dotieren Schichten (1, 2) aufweist, die eine n-dotierte Schicht einfassen, wobei die Schichten (1, 2, 3) durch unbeabsichtigt dotierte i-Abstandsschichten (8, 9) getrennt sind, um eine pinip-Struktur zu bilden, und wobei die p-dotierten Schichten an unterschiedliche Spannungen angelegt sind, die solchermaßen gewählt sind, dass die Struktur zwei hintereinander angeordnete pin- und nip-Unterstrukturen bildet, wobei eine der Unterstrukturen in Sperrrichtung polarisiert ist, während die andere Unterstruktur in Flussrichtung polarisiert ist, wobei die Modulation der Übertragungsfunktion durch ein Verschieben der eingefassten n-dotierten Schicht (3) gegenüber den beiden p-dotierten Schichten (1, 2) durch eine Änderung der jeweiligen an die pin- und nip-Unterstrukturen angelegten Polarisierugen erreicht wird.

4. Vorrichtung nach Anspruch 2 oder 3,
**dadurch gekennzeichnet, dass** sie wenigstens eine zusätzliche Halbleiterschicht mit einer Dotierung desselben Typs (n oder p) wie wenigstens eine der eine pinip- oder nipin-Struktur bildenden Halbleiterschichten (1, 2, 3) aufweist, die von dieser Schicht (1, 2, 3) durch Abstandsschichten mit einem gleichen Dotierungstyp (n oder p) wie sie selbst entfernt ist und eine Form hat, die im Wesentlichen mit der Form der Schichten (1-3) der Struktur identisch ist.

5. Vorrichtung nach einem der vorhergehenden Ansprüche,
**dadurch gekennzeichnet, dass** die jeweiligen Dicken und Zusammensetzungen der Halbleiterschichten und der Abstandsschichten solchermaßen gewählt sind, dass die Struktur eine modulierbare optische Übertragungsfunktion aufweist, die eine abstimmbare selektive Wellenlängenfilterung ausführt.

6. Vorrichtung nach einem der vorhergehenden Ansprüche,
**dadurch gekennzeichnet, dass** die jeweiligen Dicken und Zusammensetzungen der Halbleiterschichten und Abstandsschichten solchermaßen gewählt sind, dass die Struktur wenigstens eine zusätzliche modulierbare optische Übertragungsfunktion aufweist, die eine Funktion ausführt, die aus einer Gruppe gewählt ist, welche die Wellenlängenfilterung, die Kommutierung und die Abstimmbarkeit umfasst.

7. Vorrichtung nach einem der vorhergehenden Ansprüche,
**dadurch gekennzeichnet, dass** sie wenigstens eine aktive Halbleiterschicht (23) umfasst, die für die Erkennung oder Erzeugung von Licht geeignet ist.

8. Vorrichtung nach einem der vorhergehenden Ansprüche,
**dadurch gekennzeichnet, dass** wenigstens zwei (1, 2, 11) der Schichten (1-3, 11) einen ohmschen Kontakt aufweisen, der für das Anlegen elektrischer Spannung geeignet ist.

9. Vorrichtung nach einem der vorhergehenden Ansprüche,
**dadurch gekennzeichnet, dass** sie auf einem Träger (13) gebildet ist.

10. Vorrichtung nach Anspruch 9,
**dadurch gekennzeichnet, dass** sie auf dem Träger (13) mit dazwischenliegenden Abstandsschichten (14) mit ausgewählter Größe und Dotierung gebildet ist.

11. Vorrichtung nach einem der vorhergehenden Ansprüche,
**dadurch gekennzeichnet, dass** die Halbleiterschichten (1-3, 11, 15, 17, 19-20) und die Abstandsschichten (8, 9, 12, 14, 16, 18, 21, 22) aus Werkstoffen vom Typ III-V ausgeführt sind, insbesondere aus Galliumarsenid (GaAs) oder aus Indiumphosphid (InP).
